# EUROPEAN PATENT APPLICATION

(11) **EP 2 371 995 A1**
(43) Date of publication of application: **05.10.2011**
(21) Application number: 09834854.3
(22) Date of filing: 22.12.2009
(51) Int. Cl.: C25D 7/06, B32B 15/01, C23F 1/02, H05K 1/09

(54) **ROLLED COPPER FOIL OR ELECTROLYTIC COPPER FOIL FOR ELECTRONIC CIRCUIT AND METHOD OF FORMING ELECTRONIC CIRCUIT USING SAME**

(30) Priority: 26.12.2008 JP 2008334443
(71) Applicant: JX Nippon Mining & Metals Corporation, Tokyo 100-8164 (JP)
(72) Inventor: YAMANISHI Keisuke, Hitachi-city Ibaraki 317-0056 (JP); KAMINAGA Kengo, Hitachi-city Ibaraki 317-0056 (JP); FUKUCHI Ryo, Hitachi-city Ibaraki 317-0056 (JP)
(74) Representative: Hoarton, Lloyd Douglas Charles
(86) International application number: PCT/JP2009/071282
(87) International publication number: WO 2010/074053

(57) **Abstract**

Provided is a rolled copper foil or electrolytic copper foil for an electronic circuit to be used for forming a circuit by etching, wherein the rolled copper foil or the electrolytic copper foil comprises a nickel alloy layer with lower etching rate than copper, which is formed on an etching side of the copper foil, and the nickel alloy layer contains zinc. This invention aims to prevent sagging caused by the etching, to form a uniform circuit having the intended circuit width, and to shorten the time of forming a circuit by etching as much as possible, when forming a circuit by etching a copper foil of the copper-clad laminate; and also aims to make the thickness of the nickel alloy layer as thin as possible, to inhibit oxidation when exposed to heat, to prevent tarnish (discoloration) known as "YAKE", to improve the etching properties in pattern etching, and to prevent the occurrence of short circuits and defects in the circuit width.

## Description

### TECHNICAL FIELD

The present invention relates to a rolled copper foil or electrolytic copper foil for an electronic circuit to be used for forming a circuit by etching, and to a method of forming an electronic circuit by using such rolled copper foil or electrolytic copper foil.

### BACKGROUND ART

A copper foil for a printed circuit is being widely used in electronic devices and electrical equipment. This kind of copper foil for a printed circuit is generally bonded to a base material such as a synthetic resin board or a film with an adhesive or without using an adhesive under high temperature and pressure to produce a copper-clad laminate, a circuit is subsequently printed with the process steps of resist coating and exposure in order to form the intended circuit, etching treatment is further performed in order to remove any unwanted part of the copper foil, and various elements are soldered thereto in order to form a printed circuit for electronic devices.

A copper foil that is used for such a printed circuit can be broadly classified as an electrolytic copper foil and a rolled copper foil depending on the production method, but both are used according to the type or quality demand of the printed circuit board.
These copper foils have a surface that is bonded to a resin base material and a non-bonding surface, and they are respectively subject to special surface treatment (treatment process). In addition, there are cases where both surfaces are provided with a function of bonding with the resin (double treatment process); for instance, such as with a copper foil that is used as the inner layer of a multi-layered printed wiring board.

An electrolytic copper foil is generally produced by electrodepositing copper on a rotating drum, and continuously peeling this to obtain a copper foil. At this point in the production process, the surface in contact with the rotating drum is a gloss surface, and the opposite surface has numerous asperities (rough surface). Nevertheless, even with this kind of rough surface, it is standard to adhere copper particles of approximately 0.2 to 3 µm in order to further improve the adhesiveness with the resin substrate.
Moreover, there are also cases of reinforcing the foregoing asperities and forming a thin plated layer thereon for preventing the falling of the copper particles. The foregoing series of steps is referred to as roughening treatment. This kind of roughening treatment is required not only for electrolytic copper foils, but also required for rolled copper foils, and similar roughening treatment is also performed for rolled copper foils.

The foregoing copper foils are used and subject to hot pressing process or Roll-to-Roll process to produce a copper-clad laminate. To cite hot pressing process as an example, this laminate is produced through the process steps of synthesizing epoxy resin, impregnating a paper base material with phenol resin and drying this to produce a prepreg, and subjecting the prepreg and the copper foil, which are combined, to heat pressure molding with a pressing machine. In addition to the above, there is a method of drying a polyimide precursor solution on the copper foil to solidify this onto the copper foil in order to form a polyimide resin layer on the copper foil.

With the copper-clad laminate produced as described above, in order to form an intended circuit, a circuit is printed with the process steps of resist coating and exposure, and etching treatment is further performed to remove any unwanted part of the copper foil. However, when forming a circuit by etching, there is a problem in that the circuit does not have the intended circuit width.
This is because the copper portion of the copper foil circuit after etching is etched downward from the surface of the copper foil; that is, etched broader toward the resin layer (cause sagging). If large "sagging" occurs, the copper circuit will short in the vicinity of the resin substrate, and may become defective.

It is necessary to reduce such "sagging" as much as possible. Thus, in order to prevent defective etching such as etching broadened downward, attempts have been made to reduce the "sagging" by prolonging the etching time and increasing the etching process.
Nevertheless, in the foregoing case, if there is a portion that has already reached a predetermined width dimension, such portion will be additionally etched, and the circuit width of that copper foil portion will correspondingly become narrower, and the uniform line width (circuit width) that is intended in the circuit design cannot be obtained. In particular, there is a problem in that such portion (thinned portion) will generate heat and, in certain cases, become disconnected.
Under circumstances where the patterns of electronic circuits are becoming finer, problems caused by this kind of defective etching are still often encountered today, and are becoming major issues in forming circuits.

In order to overcome the foregoing problems, the present inventors proposed a copper foil in which a metal or alloy layer to be etched slower than copper was formed on the copper foil on the etching side (refer to Patent Document 1). As the metal or alloy in this case, used are nickel, cobalt and their alloys.
Upon designing a circuit, since the etching solution will infiltrate from the resist coated side, namely, from the surface of the copper foil; if there is a metal or alloy layer with a slow etching rate immediately below the resist, the etching of the portion of the copper foil in the vicinity thereof is inhibited, and the etching of the other portions of the copper foil will advance. Thus, it was possible to yield the effect of reducing the "sagging" and forming a circuit with a uniform line width. Consequently, there was a vast improvement in comparison to the conventional technology.

Here, some problems arose at the stage of making further improvements. Specifically, after forming the circuit, it was necessary to remove the resin and also necessary to remove the metal or alloy layer with a slow etching rate, which was formed for preventing the "sagging", by soft etching. In addition, it was also necessary to perform high-temperature treatment to the copper foil in the steps such that the resin is attached during the process of forming an electronic circuit with the use of a copper foil having a metal or alloy layer (nickel or nickel alloy layer) with a slow etching rate as a copper-clad laminate.

With respect to the former, in order to shorten the time required for the etching and removal process and achieve a clean removal, it is necessary to make the thickness of the nickel or nickel alloy layer as thin as possible. With respect to the latter, since it is exposed to heat, the nickel or nickel alloy layer is oxidized (commonly called "YAKE (oxidation)" since tarnish occurs), and there are problems in that the etching properties may deteriorate in the pattern etching, and defects such as short circuits or deterioration in the controllability of the circuit width may occur due to the deterioration in the resist coating properties (uniformity, adhesion) or the excessive etching of the interfacial oxide during the etching process. Thus, it is demanded that additional improvements be made, or different materials be used as a substitute therefore.

Here, there are several inventions that if the copper foil is to be exposed to heat, a zinc or zinc alloy or the like is formed on a gloss surface of the copper foil for a printed circuit for inhibiting the thermal oxidation resistance. For example, these would be Patent Document 2, Patent Document 3, Patent Document 4, Patent Document 5, Patent Document 6, and Patent Document 7. Moreover, also proposed is a method of covering the side to be bonded to the resin, or the side not to be etched, with nickel or nickel alloy.

Nevertheless, since these technologies were not proposed to prevent or inhibit the etching portion of the copper foil from being etched broader from the surface of the copper foil downward (occurrence of sagging) upon designing a copper foil circuit through etching, they are unable to resolve the foregoing problems.

Patent Document 1: Japanese Laid-Open Patent Publication No. 2002-176242
Patent Document 2: Japanese Laid-Open Patent Publication No. H5-140765
Patent Document 3: Japanese Laid-Open Patent Publication No. H6-85416
Patent Document 4: Japanese Laid-Open Patent Publication No. H6-85417
Patent Document 5: Japanese Laid-Open Patent Publication No. H6-280047
Patent Document 6: Japanese Laid-Open Patent Publication No. H7-74464
Patent Document 7: Japanese Laid-Open Patent Publication No. H7-278883
Patent Document 8: Japanese Laid-Open Patent Publication No. 2005-15861
Patent Document 9: Japanese Laid-Open Patent Publication No. 2006-261270

### DISCLOSURE OF THE INVENTION

An object of this invention is to obtain a rolled copper foil or electrolytic copper foil for an electronic circuit, wherein, upon forming a circuit by etching a copper foil of a copper-clad laminate, sagging caused by the etching is prevented, a uniform circuit having an intended circuit width can be formed, and the time of forming a circuit by etching is shortened, and wherein the thickness of a nickel alloy layer is reduced as much as possible, the removal by soft etching can be facilitated, the dissolution residue of the coating layer after being etched is prevented, oxidation is inhibited when exposed to heat, tarnish (discoloration) known as "YAKE" is prevented, the etching properties in pattern etching are improved, and the occurrence of short circuits and defects in the circuit width are prevented; and to obtain the method of forming an electronic circuit using such copper foils.

The present inventors discovered that, by forming a nickel alloy layer on the etching surface of a rolled copper foil or an electrolytic copper foil and adjusting the etching rate in the thickness direction of the copper foil, it is possible to form a circuit with a uniform circuit width without any sagging, prevent oxidation when exposed to heat in order to prevent tarnish known as "YAKE", and simultaneously resolve several other problems upon designing an electronic circuit.

Based on the foregoing discovery, the present invention provides:
1 A rolled copper foil or electrolytic copper foil for an electronic circuit, wherein the rolled copper foil or electrolytic copper foil to be used for forming an electronic circuit by etching comprises a nickel alloy layer with a lower etching rate than copper formed on an etching side of the copper foil, and the nickel alloy layer contains zinc or zinc oxide.

The present invention also provides:
2 The rolled copper foil or electrolytic copper foil for an electronic circuit according to 1 above, wherein the nickel ratio in the nickel alloy layer with a lower etching rate than copper exceeds 50 wt%; and
3 The rolled copper foil or electrolytic copper foil for an electronic circuit according to any one of 1 and 2 above, wherein the amount of zinc contained as zinc or zinc oxide in the nickel alloy layer is 30 µg/dm² to 1000 µg/dm² based on metal zinc conversion and does not exceed the amount of nickel.

The present invention further provides:
4 The rolled copper foil or electrolytic copper foil for an electronic circuit according to any one of 1 to 3 above, wherein the amount of nickel contained in the nickel alloy layer is 100 µg/dm² to 3000 µg/dm²;
5 The rolled copper foil or electrolytic copper foil for an electronic circuit according to any one of 1 to 4 above, wherein the nickel alloy layer contains one or more elements selected from phosphorus, boron, molybdenum, tungsten, and cobalt; and
6 The rolled copper foil or electrolytic copper foil for an electronic circuit according to any one of 1 to 5 above, wherein the copper foil further comprises a chromium layer or a chromate layer and/or a silane-treated layer on the nickel alloy layer.

The present invention additionally provides:
7 The rolled copper foil or electrolytic copper foil for an electronic circuit according to 6 above, wherein the amount of chromium in the case of comprising the chromium layer or chromate layer is 100 µg/dm² or less based on metal chromium conversion; and
8 The rolled copper foil or electrolytic copper foil for an electronic circuit according to 6 and 7 above, wherein the amount of silane in the case of comprising the silane-treated layer is 20 µg/dm² or less based on silicon elemental conversion.

The present invention additionally provides:
9 A method of forming an electronic circuit, the method of forming an electronic circuit by etching a copper foil of a copper-clad laminate comprising a rolled copper foil or electrolytic copper foil, wherein a nickel alloy layer containing zinc or zinc oxide is formed on the etching side of the copper foil, and thereafter the copper foil is subject to etching with an aqueous ferric chloride or an aqueous copper chloride to remove any unwanted portion of the copper foil and thereby form a copper circuit.

The present invention additionally provides:
10 A method of forming an electronic circuit, the method of forming an electronic circuit by etching a copper foil of a copper-clad laminate comprising a rolled copper foil or electrolytic copper foil, wherein the rolled copper foil or electrolytic copper foil for an electronic circuit according to any one of 1 to 8 above is subject to etching with an aqueous ferric chloride or an aqueous copper chloride to remove any unwanted portion of the copper foil and thereby form a copper circuit.

### [Effect of the Invention]

The present invention yields the effect of being able to form a more uniform circuit having an intended circuit width upon forming a circuit by etching a copper foil of a copper-clad laminate. The present invention yields the additional effects of being able to prevent sagging caused by the etching, shorten the time of forming a circuit by etching, make the thickness of the nickel or nickel alloy layer as thin as possible, inhibit oxidation when exposed to heat, and prevent tarnish known as "YAKE".
It is thereby possible to provide a rolled copper foil or electrolytic copper foil for an electronic circuit capable of improving the etching properties in pattern etching and preventing the occurrence of short circuits and defects in the circuit width, and further provide a method of forming a superior electronic circuit.

### BRIEF DESCRIPTION OF THE DRAWINGS

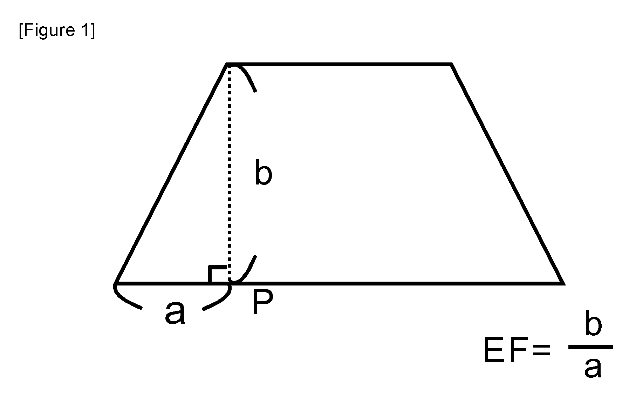

[Fig. 1] A diagram explaining the outline of the calculation method of the etching factor (EF).

### BEST MODE FOR CARRYING OUT THE INVENTION

The rolled copper foil or electrolytic copper foil for an electronic circuit to be used for forming a circuit by etching according to the present invention comprises a layer of nickel alloy, which is a metal or an alloy with a lower etching rate than copper, formed on an etching side of the rolled copper foil or electrolytic copper foil, and the nickel alloy layer enables to prevent sagging caused by the etching. The nickel alloy layer contains zinc or zinc oxide, and also functions as a heat resistance layer.
The rolled copper foil or electrolytic copper foil is bonded to a resin to form a copper-clad laminate. Both an electrolytic copper foil and a rolled copper foil can be applied as this copper foil. Moreover, any of the roughened surface (M surface) and the gloss surface (S surface) is applicable. The surface to be etched is usually the gloss surface side. A rolled copper foil includes high-purity copper foils and copper alloy foils with improved strength, and the present invention covers all of these copper foils.

The nickel or nickel alloy which inhibits etching is positioned near the resist portion on the copper foil, and the etching rate of the copper foil on the resist side is restrained due to the nickel alloy layer, and conversely, the etching of copper proceeds at a normal rate with distance from the nickel alloy layer. Consequently, etching will proceed almost vertically from the resist side of the side surface of the copper circuit toward the resin substrate side, and a rectangular copper foil circuit is formed.

As described above, since the etching solution will infiltrate from the resist coated side, namely from the surface of the copper foil, upon etching the circuit; zinc or zinc oxide will not have functions that are equal to nickel although the nickel alloy layer contains zinc or zinc oxide as an alloy component in the present invention. Rather, since a zinc or zinc oxide is easily etched when designing a circuit; based on common general technical knowledge, it is considered that a zinc or zinc oxide would increase sagging".
Nevertheless, it has been confirmed that it is possible to unexpectedly prevent "YAKE" and form a uniform circuit having the intended circuit width by causing a nickel layer with low etching rate formed on the copper foil to contain zinc or zinc oxide to form a nickel alloy layer. The effect that is yielded here is extremely significant.

It is necessary for the copper-clad laminate to be subject to high-temperature treatment upon attaching the resin in the process of forming an electronic circuit. In the foregoing case, a layer of nickel metal alone is oxidized, and the resist coating properties (uniformity, adhesion) often deteriorate. Moreover, during the etching process, the interfacial oxides formed at the time of heating often lead to variation in the etching, and cause a short circuit or non-uniformity of the circuit width.

Patent Document 9 proposes a manufacturing process of a copper-clad laminate for controlling the oxygen concentration, and it is considered that oxidation resistance against high-temperature treatment will be demanded in more strongly in the future.
Here, since zinc or zinc oxide contained in the nickel alloy layer of the present invention is a material with thermal oxidation resistance; to additionally contain zinc or zinc oxide as an alloy component will yield the effect of considerably improving the thermal oxidation resistance and tarnish prevention.

As a result of forming a thick layer of nickel metal alone, it is possible to prevent the influence of thermal oxidation, but such thick formation is in itself a problem. In other words, since nickel needs to be removed after etching, much time will be required for the removal process.
However, since the heat resistance performance can improve as a result that nickel layer contains zinc or zinc oxide, it was possible to yield a greater effect of being able to alleviate the thickness of the nickel alloy layer.
It is thereby possible to facilitate the removal of the nickel alloy layer by soft etching.

Accordingly, nickel or nickel alloy is especially effective as a metal layer with a lower etching rate than copper. With an etching solution (aqueous copper chloride, aqueous ferric chloride or the like) that is generally used for forming an electronic circuit pattern on the copper-clad laminate, so as long as it is an alloy having nickel as its primary component, it will be effective in improving the etching factor since the etching rate will be the same level as nickel, or lower than copper even if it is greater than nickel.

As described above, since zinc is a metal that is easily etched, it must be reduced from a quantitative standpoint. In the present invention, since the main object is to achieve a uniform etched width of the circuit and to prevent "sagging", the amount of metals such as zinc that are easily corroded must be kept low. In this respect, nickel must be the primary component in the nickel alloy layer.

Accordingly, as the alloy component contained in the nickel alloy as the alloy with a lower etching rate than the rolled copper foil or electrolytic copper foil for an electronic circuit, any well-known alloy component may be used. For example, an alloy of nickel and at least one or more elements selected from phosphorus, boron, molybdenum, tungsten and cobalt has an etching rate that is slower than copper, and is effective in improving the etching factor. The alloy layer of the present invention is composed of nickel-zinc alloy containing nickel as its main component. As described above, since phosphorus, boron, molybdenum, tungsten and cobalt metals have similar effect to nickel, a part of nickel can be substituted with these metals.
As to phosphorus and boron, these one or two elements can be contained, as needed, at a total of 5% or less of the nickel amount (wt%) in nickel conversion.
As to molybdenum, tungsten and cobalt, these one or more elements can be contained, as needed, at a total of 10% or less of the nickel amount (wt%) in nickel conversion.
However, the alloy layer of the present invention is composed of nickel-zinc alloy containing nickel as its main component. In view of adjustment to alloy layer and achievement of the effect of improvement in the etching factor, it is not appropriate to add the substitutable metals of phosphorus, boron, molybdenum, tungsten and cobalt beyond necessity (in large quantity). Therefore, the content of these elements should be within the foregoing range.

Here, zinc contained in the nickel alloy is not limited to metal zinc, and also includes zinc hydroxide and zinc oxide. A chromium layer or a chromate layer and/or a silane-treated layer may be additionally formed on the nickel alloy layer. Here, although there may be a difference in the etching rate relative to the pattern etching solution, as a result of adequately selecting their amounts, it is possible to inhibit the oxidation of the nickel alloy surface, and a pattern with a stable circuit width can thereby be formed.

Preferably, the total amount of zinc contained in the nickel alloy layer of the rolled copper foil or electrolytic copper foil for an electronic circuit according to the present invention is 30 µg/dm² to 1000 µg/dm² based on metal zinc conversion and does not exceed the total amount of nickel.
If it is less than 30 µg/dm², there is no oxidation resistance (inhibition of YAKE) effect. Moreover, if it exceeds 1000 µg/dm², the effect becomes saturated and the effect of nickel is offset. Thus, the total amount of zinc is preferably 30 µg/dm² to 1000 µg/dm² based on metal zinc conversion.

Moreover, it is preferable that the amount of nickel contained in the nickel alloy layer of the rolled copper foil or electrolytic copper foil for an electronic circuit is 100 µg/dm² to 3000 µg/dm². This is an amount required for inhibiting the occurrence of sagging during the etching of the circuit and etching a uniform circuit. It will be ineffective if the amount is less than 100 µg/dm². Preferably, the amount is 200 µg/dm² or more. In addition, the upper limit is set to 3000 µg/dm². If the amount is excessive, the burden of removing the nickel or nickel alloy layer during the soft etching will become significant, and in certain cases it will cause treatment residue and impair the copper circuit design. Accordingly, the amount must be within the foregoing range.

Further, if the chromium layer or the chromate layer is to be provided in the rolled copper foil or electrolytic copper foil for an electronic circuit according to the present invention, the amount of chromium is set to be 100 µg/dm² or less based on metal chromium conversion. In addition, when forming the silane-treated layer, the amount of silane is preferably 20 µg/dm² or less based on silicon elemental conversion. This is in order to inhibit differences in the etching rate relative to the pattern etching solution.
Nevertheless, an adequate amount is effective in preventing the thermal oxidation of the nickel or nickel alloy layer.

The present invention is able to additionally provide a method of forming an electronic circuit by etching a copper foil of a copper-clad laminate comprising a rolled copper foil or electrolytic copper foil, wherein a layer of nickel alloy, which is a metal or an alloy with a lower etching rate than copper, is formed on the etching side of the copper foil, and thereafter the copper foil is subject to etching with an aqueous ferric chloride or an aqueous copper chloride to form a copper circuit.
Any of the foregoing etching solutions may be used, but in particular the aqueous ferric chloride is effective. This is because the etching of a fine circuit takes time, and the aqueous ferric chloride has a faster etching rate than the aqueous copper chloride.

The present invention is also able to provide a method of forming an electronic circuit by etching a copper foil of a copper-clad laminate comprising a rolled copper foil or electrolytic copper foil, wherein the rolled copper foil or electrolytic copper foil for an electronic circuit according to any one of 1 to 8 above is subject to etching with an aqueous ferric chloride or an aqueous copper chloride to remove any unwanted portion of the copper and thereby form a copper circuit. In this method, both a rolled copper foil and an electrolytic copper foil for an electronic circuit can be used.

In a method of forming an electronic circuit by etching a copper foil of a copper-clad laminate comprising a rolled copper foil or electrolytic copper foil, after the rolled copper foil or electrolytic copper foil for an electronic circuit according to any one of 1 to 8 above is subject to etching with an aqueous ferric chloride or an aqueous copper chloride to remove any unwanted portion of the copper, the resist is removed and the residual nickel layer can be removed by soft etching.

Examples of preferred plating conditions are shown below.
(Nickel-zinc alloy plating, part 1)
Here, a plated film in a metal or alloy state is basically obtained.
Ni:5to40g/L
Zn: 0.5 to 25 g/L
pH: 3 to 3.7
Temperature: Ordinary temperature to 60°C
Current density Dk: 2 to 50 A/dm²
Time: 1 to 4 seconds

### (Nickel-zinc alloy plating, part 2)

Here, Zn is made of a zero-valent metallic state or a bivalent oxidized state (oxide or hydroxide), and the ratio of zinc in a zero-valent metallic state in the total zinc content of the nickel-zinc plating is 50% or less. Moreover, as a result of retaining this in a bath for 1 to 20 seconds after the plating, the chemical state (metal zinc/zinc oxide ratio) of Zn can be controlled.
Ni: 10 to 40 g/L
Zn: 0.5 to 7 g/L
H₂SO₄: 2 to 20 g/L
Temperature: Ordinary temperature to 60°C
Current density Dk: 10 to 50 A/dm²
Time: 1 to 4 seconds

(Nickel-cobalt-zinc alloy plating)
Ni: 1 to 20 g/L
Co: 1 to 20 g/L
Zn: 0.1 to 10 g/L
pH: 2.5 to 3.5
Temperature: Ordinary temperature to 60°C
Current density Dk: 1 to 15 A/dm²
Time: 1 to 10 seconds

(Nickel-phosphorus-zinc alloy plating)
Ni: 50 to 100 g/L
P: 1 to 25 g/L
HBO₃: 0 to 30 g/L
Zn: 3 to 20 g/L
pH: 0.5 to 2.5
Temperature: Ordinary temperature to 95°C
Current density Dk: 5 to 40 A/dm²
Time: 1 to 10 seconds

(Nickel-molybdenum-zinc alloy plating)
Ni: 5 to 25 g/L
Mo: 0.01 to 5 g/L
Na₂P₂O₇: 160 g/L
Zn:0.1 to 10 g/L
pH: 8 to 9
Temperature: Ordinary temperature to 40°C
Current density Dk: 1 to 5 A/dm²
Time: 1 to 10 seconds

(Nickel-tungsten-zinc alloy plating)
Ni: 1 to 10 g/L
W: 20 to 50 g/L
Citric acid: 60 g/L
Zn: 0.1 to 10 g/L
pH: 8 to 9
Temperature: Ordinary temperature to 50°C
Current density Dk: 0.1 to 5 A/dm²
Time: 1 to 10 seconds

(Nickel-boron-zinc alloy plating)
Nickel sulfate: 25 to 35 g/L
Zn: 0.5 g/L
Dimethylamine-borane: 2 to 3 g/L
Glycolic acid: 25 to 35 g/L
Acetic acid: 15 g/L
pH: 6 to 7
Temperature: 50°C to 70°C
Current density Dk: 1 to 10 A/dm²
Time: 1 to 10 seconds

(Nickel plating)
Ni: 10 to 40 g/L
pH: 2.5 to 3.5
Temperature: Ordinary temperature to 60°C
Current density Dk: 2 to 50 A/dm²
Time: 1 to 4 seconds

(Zinc plating)
Zn: 1 to 20 g/L
pH: 3 to 3.7
Temperature: Ordinary temperature to 60°C
Current density Dk: 1 to 15 A/dm²
Time: 1 to 10 seconds

(Chromium plating conditions)
K₂Cr₂O₇ (Na₂Cr₂O₇ or CrO₃)
Cr: 40 to 300 g/L
H₂SO₄: 0.5 to 10.0 g/L
Bath temperature: 40 to 60°C
Current density Dk: 0.01 to 50 A/dm²
Time: 1 to 100 seconds
Anode: Pt-Ti plate, stainless steel plate, lead plate, etc.

(Chromate treatment conditions)
(a) Example of dip chromate treatment
   CrO₃ or K₂Cr₂O₇: 1 to 12 g/L
   Zn(OH)₂ or ZnSO₄ • 7H₂O: 0(0.05) to 10 g/L
   Na₂SO₄: 0(0.05) to 20 g/L
   pH: 2.5 to 12.5
   Temperature: 20 to 60°C
   Time: 0.5 to 20 seconds
(b) Example of electrolytic chromate treatment
   CrO₃ or K₂Cr₂O₇: 1 to 12 g/L
   Zn(OH)₂ or ZnSO₄ • 7H₂O: 0(0.05) to 10 g/L
   Na₂SO₄: 0(0.05) to 20 g/L
   pH: 2.5 to 12.5
   Temperature: 20 to 60°C
   Current density: 0.5 to 5 A/dm²
   Time: 0.5 to 20 seconds

(Silane treatment conditions)
Silane is selected from the various systems shown below.
Concentration: 0.01 wt% to 5 wt%
Type: olefin-system silane, epoxy-system silane, acrylic-system silane, amino-system silane, mercapto-system silane
Silane dissolved in alcohol is diluted with water up to a prescribed concentration, and applied to the copper foil surface.

### (Method of analyzing amount of nickel and zinc adhesion)

In order to analyze the surface treated with nickel and zinc, the opposite surface is prepared with FR-4 resin by press work, and subsequently masked. A sample thereof is dissolved in nitric acid with a concentration of 30% until the surface treatment coating is dissolved, the solution inside the beaker is diluted tenfold, and the quantitative analysis of nickel is performed with atomic absorption spectrometry.

### (Method of analyzing amount of chromium adhesion)

In order to analyze the treated surface, the opposite surface is prepared with FR-4 resin by press work, and subsequently masked. A sample thereof is boiled for 3 minutes in hydrochloric acid with a concentration of 10% to dissolve the treated layer, and this solution is used to perform the quantitative analysis of zinc and chromium with atomic absorption spectrometry.

### (Consideration of thermal influence)

During the stage of producing the copper-clad laminate (CCL), the copper foil is exposed to heat. Due to this heat, the etching improvement treated layer provided to the copper foil surface will diffuse to the copper layer. Thus, the initially expected etching improvement effect will diminish, and the etching factor tends to decrease. In light of the above, in order to yield the same effect as a non-diffused state, it is necessary to increase the amount of adhesion of the improvement treated layer by 1.1 to 2 times in consideration of the heat quantity to which the copper foil is exposed during the production of the CCL.

When etching the copper foil of the copper-clad laminate, after forming an alloy layer with a lower etching rate than copper on the etching side of the copper foil of the present invention, the copper foil is etched using an aqueous copper chloride or an aqueous ferric chloride.
As a result of performing etching under the foregoing conditions, it is possible to achieve an etching factor of 2 or more; that is, it is possible to make the inclination angle between the etching side of the copper foil circuit and the resin substrate to be 63 degrees or more, preferably 70 degrees or more. A more preferable inclination angle is within the range of 80 to 95 degrees. It is thereby possible to form a rectangular etched circuit that is free from sagging.

### (Soft etching properties)

Generally speaking, soft etching properties are examined by immersing the specimen in a solution of sulfuric acid-hydrogen peroxide mixing system for 2 minutes, and confirming the external appearance as to whether the plating has been removed. As an example of a soft etching solution, for instance, 165 g/L of sulfuric acid and 21 g/L of hydrogen peroxide are used. Under normal circumstances, soft etching is performed at 35°C. In the observation of the external appearance, complete removal is considered favorable, and any unremoved portions are considered inferior.
What is particularly noteworthy in soft etching is the case where the Ni alloy layer remains. If there is any residual Ni alloy layer, the plating properties may change. From this perspective, it is also necessary to pay attention to the soft etching properties.

### [Examples]

The Examples and Comparative Examples of the present invention are now explained. Incidentally, these Examples are merely illustrative, and the present invention shall in no way be limited thereby. In other words, various modifications and other embodiments based on the technical spirit claimed in the claims shall be covered by the present invention as a matter of course.

### (Example 1)

electrolytic copper foil of 5 µm was used. The surface roughness Rz of the electrolytic copper foil was 3 µm. Under the foregoing nickel-zinc alloy plating (part 1) conditions, a nickel-zinc alloy plated layer of 390 µg/dm² was formed on the gloss (S) surface of the electrolytic copper foil.
As shown in Table 1, the nickel content was 350 µg/dm² and the zinc content was 40 µg/dm² in the nickel-zinc alloy plated layer. The nickel ratio was 90 wt%. The copper foil was bonded to a resin substrate with the adhesive surface opposite to the surface provided with the nickel-zinc alloy plated layer.

Subsequently, a circuit with 10 lines was printed with the process steps of resist coating and exposure, and etching treatment was further performed to remove any unwanted part of the copper foil. The etching conditions, circuit forming conditions, measurement conditions of the etching factor, and YAKE experiment were as follows.
(Etching conditions)
Aqueous ferric chloride: (37 wt%, Baume degree: 40°)
Solution temperature: 50°C
Spray pressure: 0.15 MPa

### (Circuit forming conditions)

Circuit pitch: There are two types of circuit pitches; namely, a 30 µm pitch and a 50 µm pitch, and the circuit pitch is changed according to the thickness of the copper foil. In the case of Example 1, the following conditions were adopted since a copper foil with a thickness of 5 µm was used.
(Formation of a circuit with 30 µm pitch)
The following conditions were adopted since a copper foil with a thickness of 5 µm was used in Example 1.
Resist L/S = 25 µm/5 µm; top (upper part) width of finished circuit: 10 µm; etching time: around 48 seconds

### (Measurement conditions of etching factor)

In cases where etching is broadened downward (in cases where sagging occurs); if the intersection point of the perpendicular from the upper surface of the copper foil, on the assumption that the circuit was etched vertically, with the resin substrate is regarded as point P, and if the sagging length from the point P is regarded as distance "a", the etching factor shows the ratio (b/a) of the distance "a" to the thickness "b" of the copper foil. The larger the numerical value of the etching factor is, the greater the inclination angle will be. This means that etching residue will lessen and sagging will diminish.
The outline of the calculation method of the etching factor (EF) is shown in Fig. 1. As shown in Fig. 1, the calculation is performed as EF = b/a. As a result of using this etching factor, the quality of the etching properties can be easily determined.

### (YAKE experiment)

Under ambient atmosphere, the copper foil was retained at 240°C for 10 minutes to confirm the status of tarnish. These conditions are based on the assumption that the copper foil provided with a nickel-zinc alloy plated layer as the etching side is bonded to the resin substrate and a copper-clad laminate is formed thereby.

### (Removal performance by soft etching)

The copper foil was immersed and stirred in a mixed solution of sulfuric acid and hydrogen peroxide (165 g/L of sulfuric acid and 21 g/L of hydrogen peroxide) at 35°C for 2 minutes, and the external appearance was observed for removal of the Ni layer. In the observation of the external appearance, complete removal is considered favorable, and any unremoved portions are considered inferior.

Etching was performed under the foregoing conditions. Consequently, etching proceeded almost vertically from the resist side of the side surface of the copper circuit toward the resin substrate side, and a rectangular copper foil circuit was formed. Subsequently, the inclination angle of the etched copper foil was measured (it is the minimum value of the inclination angle in the circuit length of 100 µm).
Moreover, the etching factor and the oxidative discoloration (YAKE) of the nickel-zinc alloy plated surface were examined. The foregoing results are shown in Table 1.

As shown in Table 1, the average value of the inclination angle of both sides was 72 degrees, and an approximately rectangular copper foil circuit was formed. The etching factor was 3.0 with the 30 µm pitch.
A favorable etched circuit was thereby obtained. In addition, no oxidative discoloration (YAKE) of the nickel-zinc alloy plated surface was acknowledged. The reason for this is considered to be because the nickel-zinc alloy plated layer on the copper foil was able to prevent the oxidative discoloration of the nickel-zinc alloy plated surface which is caused by the heating during the process of being bonded to the resin.
Moreover, the etching factor did not deteriorate due to the existence of zinc in the alloy, and this is worthy of special mention.

### (Example 2)

A rolled copper foil with a foil thickness of 18 µm was used. The surface roughness Rz of the rolled copper foil was 0.7 µm. Under the foregoing nickel-zinc alloy plating (part 2) conditions, a nickel-zinc alloy plated layer of 2150 µg/dm² was formed on the rolled copper foil.
As shown in Table 1, the nickel content was 1500 µg/dm² and the zinc content was 650 µg/dm² in the nickel-zinc alloy plated layer. The nickel ratio was 70 wt%.
Moreover, the copper foil was bonded to a resin substrate with the adhesive surface opposite to the surface provided with the nickel-zinc alloy plated layer.

Subsequently, as with Example 1, a circuit with 10 lines was printed with the process steps of resist coating and exposure, and etching treatment was further performed to remove any unwanted part of the copper foil.
The etching conditions, measurement conditions of the etching factor, and YAKE experiment, but excluding the circuit forming conditions, were the same as Example 1. Thus, the description of conditions that overlap with Example 1 is omitted.

### (Formation of a circuit with 50 µm pitch)

Resist L/S = 33 µm/17 µm; top (upper part) width of finished circuit: 15 µm; etching time: around 105 seconds

Etching was performed under the foregoing conditions. Consequently, etching proceeded almost vertically from the resist side of the side surface of the copper circuit toward the resin substrate side, and a rectangular copper foil circuit was formed. Subsequently, the inclination angle of the etched copper foil was measured (it is the minimum value of the inclination angle in the circuit length of 100 µm).
Moreover, the etching factor and the oxidative discoloration (YAKE) of the nickel-zinc alloy plated surface were examined. The foregoing results are shown in Table 1.

As shown in Table 1, the average value of the inclination angle of both sides was 74 degrees, and an approximately rectangular copper foil circuit was formed. The etching factor was 3.4 with the 50 µm pitch.
A favorable etched circuit was thereby obtained. In addition, no oxidative discoloration (YAKE) of the nickel-zinc alloy plated surface was acknowledged. The reason for this is considered to be because the nickel-zinc alloy plated layer on the copper foil was able to prevent the oxidative discoloration which is caused by the heating during the process of being bonded to the resin.
Moreover, as with Example 1, the etching factor did not deteriorate due to the existence of zinc in the alloy.

### (Example 3)

A rolled copper foil with a foil thickness of 18 µm was used. The surface roughness Rz of the rolled copper foil was 0.7 µm. Under the foregoing nickel-cobalt-zinc alloy plating conditions, a nickel-cobalt-zinc alloy plated layer was formed on the rolled copper foil. Here, the amount substituted with cobalt was 8% of the nickel amount based on nickel conversion.
As shown in Table 1, the nickel content was 2500 µg/dm² and the zinc content was 300 µg/dm² in the nickel-cobalt-zinc alloy layer. The nickel ratio was 89 wt%. This nickel ratio means a total amount of cobalt and nickel based on nickel conversion.
Moreover, the copper foil was bonded to a resin substrate with the adhesive surface opposite to the surface provided with the nickel-cobalt-zinc alloy plated layer.

Subsequently, as with Example 1, a circuit with 10 lines was printed with the process steps of resist coating and exposure, and etching treatment was further performed to remove any unwanted part of the copper foil.
The etching conditions, measurement conditions of the etching factor, and YAKE experiment, but excluding the circuit forming conditions, were the same as Example 1. Thus, the description of conditions that overlap with Example 1 is omitted.

### (Formation of a circuit with 50 µm pitch)

Resist L/S = 33 µm/17 µm; top (upper part) width of finished circuit: 15 µm; etching time: around 105 seconds

Etching was performed under the foregoing conditions. Consequently, etching proceeded almost vertically from the resist side of the side surface of the copper circuit toward the resin substrate side, and a rectangular copper foil circuit was formed. Subsequently, the inclination angle of the etched copper foil was measured (it is the minimum value of the inclination angle in the circuit length of 100 µm).
Moreover, the etching factor and the oxidative discoloration (YAKE) of the nickel plated surface were examined. The foregoing results are shown in Table 1.

As shown in Table 1, the average value of the inclination angle of both sides was 74 degrees, and an approximately rectangular copper foil circuit was formed. The etching factor was 3.5 with the 50 µm pitch.
A favorable etched circuit was thereby obtained. In addition, no oxidative discoloration (YAKE) of the nickel-cobalt-zinc alloy plated surface was acknowledged. The reason for this is considered to be because the nickel-cobalt-zinc alloy plated layer on the copper foil was able to prevent the oxidative discoloration which is caused by the heating during the process of being bonded to the resin.
Moreover, as with Example 1, the etching factor did not deteriorate due to the existence of zinc in the alloy. The addition of cobalt could similarly effective if the addition was made within a range of 10% or less of the nickel amount (wt%) based on nickel conversion.

### (Example 4)

An electrolytic copper foil of 5 µm was used. The surface roughness Rz of the electrolytic copper foil was 3 µm. Under the foregoing nickel-phosphorus-zinc alloy plating conditions, a nickel-phosphorus-zinc alloy plated layer was formed on the gloss (S) surface of the electrolytic copper foil. As shown in Table 1, the nickel content was 110 µg/dm² and the zinc content was 40 µg/dm² in the nickel-phosphorus-zinc alloy plated layer. Here, the amount substituted with phosphorus was 3% of the nickel amount based on nickel conversion. The nickel ratio was 74 wt%. This nickel ratio means a total amount of phosphorus and nickel based on nickel conversion. Moreover, the copper foil was bonded to a resin substrate with the adhesive surface opposite to the surface provided with the nickel-phosphorus-zinc alloy plated layer.

Subsequently, as with Example 1, a circuit with 10 lines was printed with the process steps of resist coating and exposure, and etching treatment was further performed to remove any unwanted part of the copper foil.
The etching conditions, measurement conditions of the etching factor, and YAKE experiment, but excluding the circuit forming conditions, were the same as Example 1. Thus, the description of conditions that overlap with Example 1 is omitted.

### (Formation of a circuit with 30 µm pitch)

The following conditions were adopted since a copper foil with a thickness of 5 µm was used in Example 4.
Resist L/S = 25 µm/5 µm; top (upper part) width of finished circuit: 10 µm; etching time: around 48 seconds

Etching was performed under the foregoing conditions. Consequently, etching proceeded almost vertically from the resist side of the side surface of the copper circuit toward the resin substrate side, and a rectangular copper foil circuit was formed. Subsequently, the inclination angle of the etched copper foil was measured (it is the minimum value of the inclination angle in the circuit length of 100 µm).
Moreover, the etching factor and the oxidative discoloration (YAKE) of the nickel plated surface were examined. The foregoing results are shown in Table 1.

As shown in Table 1, the average value of the inclination angle of both sides was 70 degrees, and an approximately rectangular copper foil circuit was formed. The etching factor was 2.8 with the 30 µm pitch.
A favorable etched circuit was thereby obtained. In addition, no oxidative discoloration (YAKE) of the nickel-phosphorus-zinc alloy plated surface was acknowledged. The reason for this is considered to be because the nickel-phosphorus-zinc alloy plated layer on the copper foil was able to prevent the oxidative discoloration which is caused by the heating during the process of being bonded to the resin.
Moreover, as with Example 1, the etching factor did not deteriorate due to the existence of zinc in the alloy. The addition of phosphorus could similarly effective if the addition was made within a range of 5% or less of the nickel amount (wt%) based on nickel conversion.

### (Example 5)

A rolled copper foil of 9 µm was used. The surface roughness Rz of the rolled copper foil was 0.5 µm. Under the foregoing nickel-molybdenum-zinc alloy plating conditions, a nickel-molybdenum-zinc alloy plated layer was formed on a surface of the rolled copper foil.
As shown in Table 1, the nickel content was 250 µg/dm² and the zinc content was 50 µg/dm² in the nickel-molybdenum-zinc alloy plated layer. Here, the amount substituted with molybdenum was 9% of the nickel amount based on nickel conversion. The nickel ratio was 84 wt%. This nickel ratio means a total amount of molybdenum and nickel based on nickel conversion. The copper foil was bonded to a resin substrate with the adhesive surface opposite to the surface provided with the nickel-molybdenum-zinc alloy plated layer.

Subsequently, as with Example 1, a circuit with 10 lines was printed with the process steps of resist coating and exposure, and etching treatment was further performed to remove any unwanted part of the copper foil.
The etching conditions, measurement conditions of the etching factor, and YAKE experiment, but excluding the circuit forming conditions, were the same as Example 1. Thus, the description of conditions that overlap with Example 1 is omitted.

### (Formation of a circuit with 30 µm pitch)

Resist L/S = 25 µm/5 µm; top (upper part) width of finished circuit: 10 µm; etching time: around 48 seconds

Etching was performed under the foregoing conditions. Consequently, etching proceeded almost vertically from the resist side of the side surface of the copper circuit toward the resin substrate side, and a rectangular copper foil circuit was formed. Subsequently, the inclination angle of the etched copper foil was measured (it is the minimum value of the inclination angle in the circuit length of 100 µm).
Moreover, the etching factor and the oxidative discoloration (YAKE) of the nickel-molybdenum-zinc alloy plated surface were examined. The foregoing results are shown in Table 1.

As shown in Table 1, the average value of the inclination angle of both sides was 63 degrees, and an approximately rectangular copper foil circuit was formed. The etching factor was 2.0 with the 30 µm pitch.
A usable etched circuit was thereby obtained. In addition, no oxidative discoloration (YAKE) of the nickel-molybdenum-zinc alloy plated surface was acknowledged. The reason for this is considered to be because the nickel-molybdenum-zinc alloy plated layer on the copper foil was able to prevent the oxidative discoloration which is caused by the heating during the process of being bonded to the resin.
Moreover, as with Example 1, the etching factor did not deteriorate due to the existence of zinc in the alloy. The addition of molybdenum could similarly effective if the addition was made within a range of 10% or less of the nickel amount (wt%) based on nickel conversion.

### (Example 6)

A rolled copper foil of 9 µm was used in Example 6. Under the foregoing nickel-tungsten-zinc alloy plating conditions, a nickel-tungsten-zinc alloy plated layer was formed on a surface of the rolled copper foil.
As shown in Table 1, the nickel content was 920 µg/dm² and the zinc content was 550 µg/dm² in the nickel-tungsten-zinc alloy plated layer.
Here, the amount substituted with tungsten was 6% of the nickel amount based on nickel conversion. The nickel ratio was 65 wt%. This nickel ratio means a total amount of tungsten and nickel based on nickel conversion.
The copper foil was bonded to a resin substrate with the adhesive surface opposite to the surface provided with the nickel-tungsten-zinc alloy plated layer.

Subsequently, as with Example 1, a circuit with 10 lines was printed with the process steps of resist coating and exposure, and etching treatment was further performed to remove any unwanted part of the copper foil.
The etching conditions, measurement conditions of the etching factor, and YAKE experiment, but excluding the circuit forming conditions, were the same as Example 1. Thus, the description of conditions that overlap with Example 1 is omitted.

### (Formation of a circuit with 30 µm pitch)

Resist L/S = 25 µm/5 µm; top (upper part) width of finished circuit: 10 µm; etching time: around 76 seconds

Etching was performed under the foregoing conditions. Consequently, etching proceeded almost vertically from the resist side of the side surface of the copper circuit toward the resin substrate side, and a rectangular copper foil circuit was formed. Subsequently, the inclination angle of the etched copper foil was measured (it is the minimum value of the inclination angle in the circuit length of 100 µm).
Moreover, the etching factor and the oxidative discoloration (YAKE) of the nickel-tungsten-zinc alloy plated surface were examined. The foregoing results are shown in Table 1.

As shown in Table 1, the average value of the inclination angle of both sides was 72 degrees, and an approximately rectangular copper foil circuit was formed. The etching factor was 3.0 with the 30 µm pitch.
A favorable etched circuit was thereby obtained. In addition, no oxidative discoloration (YAKE) of the nickel-tungsten-zinc alloy plated surface was acknowledged. The reason for this is considered to be because the nickel-tungsten-zinc alloy plated layer on the copper foil was able to prevent the oxidative discoloration which is caused by the heating during the process of being bonded to the resin.
Moreover, as with Example 1, the etching factor did not deteriorate due to the existence of zinc in the alloy.
Incidentally, soft etching was performed and an observation was made about the plating residue in the Example, but no residue was confirmed since a total amount of Ni was within an appropriate range, and a favorable result was obtained. Moreover, the addition of tungsten could similarly effective if the addition was made within a range of 10% or less of the nickel amount (wt%) based on nickel conversion.

### (Example 7)

A rolled copper foil of 18 µm was used in Example 7. Under the foregoing nickel-boron-zinc alloy plating conditions, a nickel-boron-zinc alloy layer was formed on a surface of the rolled copper foil.
As shown in Table 1, the nickel content was 800 µg/dm² and the zinc content was 200 µg/dm² in the nickel-boron-zinc alloy plated layer. Here, the amount substituted with boron was 4% of the nickel amount based on nickel conversion. The nickel ratio was 81 wt%. This nickel ratio means a total amount of boron and nickel based on nickel conversion. The copper foil was bonded to a resin substrate with the adhesive surface opposite to the surface provided with the nickel-boron-zinc alloy plated layer.

Subsequently, as with Example 1, a circuit with 10 lines was printed with the process steps of resist coating and exposure, and etching treatment was further performed to remove any unwanted part of the copper foil.
The etching conditions, measurement conditions of the etching factor, and YAKE experiment, but excluding the circuit forming conditions, were the same as Example 1. Thus, the description of conditions that overlap with Example 1 is omitted.

### (Formation of a circuit with 30 µm pitch)

Resist L/S = 25 µm/5 µm; top (upper part) width of finished circuit: 10 µm; etching time: around 76 seconds

Etching was performed under the foregoing conditions. Consequently, etching proceeded almost vertically from the resist side of the side surface of the copper circuit toward the resin substrate side, and a rectangular copper foil circuit was formed. Subsequently, the inclination angle of the etched copper foil was measured (it is the minimum value of the inclination angle in the circuit length of 100 µm).
Moreover, the etching factor and the oxidative discoloration (YAKE) of the nickel-boron-zinc alloy plated surface were examined. The foregoing results are shown in Table 1.

As shown in Table 1, the average value of the inclination angle of both sides was 72 degrees, and an approximately rectangular copper foil circuit was formed. The etching factor was 3.1 with the 50 µm pitch.
A favorable etched circuit was thereby obtained. In addition, no oxidative discoloration (YAKE) of the nickel-boron-zinc alloy plated surface was acknowledged. The reason for this is considered to be because the nickel-boron-zinc alloy plated layer on the copper foil was able to prevent the oxidative discoloration which is caused by the heating during the process of being bonded to the resin.
Moreover, as with Example 1, the etching factor did not deteriorate due to the existence of zinc in the alloy.
Incidentally, soft etching was performed and an observation was made about the plating residue in the Example, but no residue was confirmed since a total amount of Ni was within an appropriate range, and a favorable result was obtained. The addition of boron could similarly effective if the addition was made within a range of 5% or less of the nickel amount (wt%) based on nickel conversion.

### (Comparative Example 1)

A rolled copper foil of 9 µm was used. Nickel plating was performed under the foregoing conditions. The surface roughness Rz of the rolled copper foil was 0.5 µm. As shown in Table 1, a nickel plated layer of 550 µg/dm² was formed on the rolled copper foil under the foregoing nickel plating conditions without performing zinc plating. Moreover, the copper foil was bonded to a resin substrate with the adhesive surface opposite to the surface provided with the nickel plated layer.

Subsequently, as with Example 1, a circuit with 10 lines was printed with the process steps of resist coating and exposure, and etching treatment was further performed to remove any unwanted part of the copper foil.
The etching conditions, measurement conditions of the etching factor, and YAKE experiment, but excluding the circuit forming conditions, were the same as Example 1. Thus, the description of conditions that overlap with Example 1 is omitted.

### (Formation of a circuit with 30 µm pitch)

Resist L/S = 25 µm/5 µm; top (upper part) width of finished circuit: 10 µm; etching time: around 76 seconds

Etching was performed under the foregoing conditions. Consequently, etching proceeded almost vertically from the resist side of the side surface of the copper circuit toward the resin substrate side, but a copper foil circuit was formed rather broader toward the end. Subsequently, the inclination angle of the etched copper foil was measured (it is the minimum value of the inclination angle in the circuit length of 100 µm).
Moreover, the etching factor and the oxidative discoloration (YAKE) of the nickel plated surface were examined. The foregoing results are shown in Table 1.

As shown in Table 1, the average value of the inclination angle of both sides was 68 degrees, and an approximately rectangular copper foil circuit was formed. The etching factor was 2.8 with the 30 µm pitch.
Consequently, a slightly favorable etched circuit was obtained. Nevertheless, oxidative discoloration (YAKE) appeared considerably on the nickel plated surface. This may result in defective etching properties in pattern etching, which is a subsequent treatment, or cause short circuits or defective circuit width.

### (Comparative Example 2)

A rolled copper foil of 18 µm was used. The surface roughness Rz of the rolled copper foil was 0.7 µm. As shown in Table 1, a zinc plated layer of 270 µg/dm² was formed on the rolled copper foil. Without forming a nickel plated layer, the copper foil was bonded to a resin substrate with the adhesive surface opposite to the surface provided with the zinc plated layer.

Subsequently, as with Example 1, a circuit with 10 lines was printed with the process steps of resist coating and exposure, and etching treatment was further performed to remove any unwanted part of the copper foil.
The etching conditions, measurement conditions of the etching factor, and YAKE experiment, but excluding the circuit forming conditions, were the same as Example 1. Thus, the description of conditions that overlap with Example 1 is omitted.
(Formation of a circuit with 50 µm pitch)
Resist L/S = 33 µm/17 µm; top (upper part) width of finished circuit: 15 µm; etching time: around 105 seconds

Etching was performed under the foregoing conditions. Consequently, etching proceeded from the resist side of the side surface of the copper circuit toward the resin substrate side, but a copper foil circuit was formed broader toward the end. Subsequently, the inclination angle of the etched copper foil was measured (it is the minimum value of the inclination angle in the circuit length of 100 µm).
Moreover, the etching factor and the oxidative discoloration (YAKE) of the nickel plated surface were examined. The foregoing results are also shown in Table 1. As shown in Table 1, the average value of the inclination angle of both sides was 48 degrees, and a trapezoidal copper foil circuit with inferior etching properties was formed. The etching factor was 1.1 with the 50 µm pitch, and became inferior. Nevertheless, there was no oxidative discoloration (YAKE) of the copper foil surface.

### (Comparative Example 3)

An electrolytic copper foil of 5 µm was used. The surface roughness Rz of the electrolytic copper foil was 3 µm. As shown in Table 1, a zinc plated layer of 240 µg/dm² was formed on the gloss (S) surface of the electrolytic copper foil. Without forming a nickel plated layer thereon, the copper foil was bonded to a resin substrate with the adhesive surface opposite to the surface provided with the zinc plated layer.

Subsequently, as with Example 1, a circuit with 10 lines was printed with the process steps of resist coating and exposure, and etching treatment was further performed to remove any unwanted part of the copper foil.
The etching conditions, measurement conditions of the etching factor, and YAKE experiment, but excluding the circuit forming conditions, were the same as Example 1. Thus, the description of conditions that overlap with Example 1 is omitted.
(Formation of a circuit with 30 µm pitch)
Resist L/S = 25 µm/5 µm; top (upper part) width of finished circuit: 15 µm; etching time: around 48 seconds

Etching was performed under the foregoing conditions. Consequently, etching proceeded from the resist side of the side surface of the copper circuit toward the resin substrate side, but a copper foil circuit was formed broader toward the end. Subsequently, the inclination angle of the etched copper foil was measured (it is the minimum value of the inclination angle in the circuit length of 100 µm).
Moreover, the etching factor and the oxidative discoloration (YAKE) of the nickel plated surface were examined. The foregoing results are also shown in Table 1. As shown in Table 1, the average value of the inclination angle of both sides was 54 degrees, and a trapezoidal copper foil circuit with inferior etching properties was formed. The etching factor was 1.4 with the 30 µm pitch, and became inferior. Nevertheless, there was no oxidative discoloration (YAKE) of the copper foil surface.

### (Comparative Example 4)

A rolled copper foil of 9 µm was used. The surface roughness Rz of the rolled copper foil was 3 µm. As shown in Table 1, a zinc plated layer of 270 µg/dm² was formed on the rolled copper foil. Without forming a nickel plated layer thereon, the copper foil was bonded to a resin substrate with the adhesive surface opposite to the surface provided with the zinc plated layer.

Subsequently, as with Example 1, a circuit with 10 lines was printed with the process steps of resist coating and exposure, and etching treatment was further performed to remove any unwanted part of the copper foil.
The etching conditions, measurement conditions of the etching factor, and YAKE experiment, but excluding the circuit forming conditions, were the same as Example 1. Thus, the description of conditions that overlap with Example 1 is omitted.
(Formation of a circuit with 30 µm pitch)
Resist L/S = 25 µm/5 µm; top (upper part) width of finished circuit: 10 µm; etching time: around 76 seconds

Etching was performed under the foregoing conditions. Consequently, etching proceeded from the resist side of the side surface of the copper circuit toward the resin substrate side, but a copper foil circuit was formed broader toward the end. Subsequently, the inclination angle of the etched copper foil was measured (it is the minimum value of the inclination angle in the circuit length of 100 µm).
Moreover, the etching factor and the oxidative discoloration (YAKE) of the nickel plated surface were examined. The foregoing results are also shown in Table 1. As shown in Table 1, the average value of the inclination angle of both sides was 52 degrees, and a trapezoidal copper foil circuit with inferior etching properties was formed. The etching factor was 1.3 with the 30 µm pitch, and became inferior. Nevertheless, there was no oxidative discoloration (YAKE) of the copper foil surface.

### (Comparative Example 5)

A rolled copper foil of 18 µm was used. The surface roughness Rz of the rolled copper foil was 0.7 µm. As shown in Table 1, a nickel-zinc alloy layer of 1500 µg/dm² (the nickel amount of 1000 µg/dm² and the zinc amount of 500 µg/dm²) was formed on the rolled copper foil, and a zinc plated layer of 1250 µg/dm² was formed thereon. The nickel ratio was 36 wt%. The copper foil was bonded to a resin substrate with the adhesive surface opposite to the surface provided with the nickel-zinc alloy plated layer and the zinc plated layer.

Subsequently, as with Example 1, a circuit with 10 lines was printed with the process steps of resist coating and exposure, and etching treatment was further performed to remove any unwanted part of the copper foil.
The etching conditions, measurement conditions of the etching factor, and YAKE experiment, but excluding the circuit forming conditions, were the same as Example 1. Thus, the description of conditions that overlap with Example 1 is omitted.

### (Formation of a circuit with 50 µm pitch)

Resist L/S = 33 µm/17 µm; top (upper part) width of finished circuit: 15 µm; etching time: around 105 seconds

Etching was performed under the foregoing conditions. Consequently, etching proceeded from the resist side of the side surface of the copper circuit toward the resin substrate side, but a copper foil circuit was formed broader toward the end. Subsequently, the inclination angle of the etched copper foil was measured (it is the minimum value of the inclination angle in the circuit length of 100 µm).
Moreover, the etching factor and the oxidative discoloration (YAKE) of the nickel plated surface were examined. The foregoing results are also shown in Table 1. As shown in Table 1, the average value of the inclination angle of both sides was 52 degrees, and a trapezoidal copper foil circuit with inferior etching properties was formed. The etching factor was 1.9 with the 50 µm pitch, and became inferior.
It is considered that defective etching occurred because a total amount of zinc was larger than the Ni amount. Therefore, the zinc amount must be appropriately controlled. There was no oxidative discoloration (YAKE) of the copper foil surface.

As evident from Table 1, when comprising a nickel alloy layer with a lower etching rate than copper formed on the copper foil, and a heat resistance layer composed of zinc or zinc alloy or its oxide formed on the nickel alloy layer; it was able to form an approximately rectangular copper foil circuit with use of either the rolled copper foil or the electrolytic copper foil, and extremely favorable etched circuit was obtained.
Meanwhile, those that did not satisfy the conditions of the present invention caused considerable sagging, a trapezoidal copper foil circuit was formed, and this resulted in defective etching. In addition, YAKE occurred in cases where a zinc or zinc alloy layer was not provided.

### (Comparative Example 6)

A rolled copper foil of 9 µm was used. The surface roughness Rz of the rolled copper foil was 0.5 µm. As shown in Table 1, a nickel alloy layer of 2250 µg/dm² was formed on the rolled copper foil. Here, the nickel content was 650 µg/dm² and the zinc content was 1600 µg/dm² in the nickel alloy layer. The nickel ratio was 29 wt%. The copper foil was bonded to a resin substrate with the adhesive surface opposite to the surface provided with the nickel alloy plated layer.

Subsequently, as with Example 1, a circuit with 10 lines was printed with the process steps of resist coating and exposure, and etching treatment was further performed to remove any unwanted part of the copper foil.
The etching conditions, measurement conditions of the etching factor, and YAKE experiment, but excluding the circuit forming conditions, were the same as Example 1. Thus, the description of conditions that overlap with Example 1 is omitted.
(Formation of a circuit with 30 µm pitch)
Resist L/S = 25 µm/5 µm; top (upper part) width of finished circuit: 10 µm; etching time: around 76 seconds

Etching was performed under the foregoing conditions. Consequently, etching proceeded from the resist side of the side surface of the copper circuit toward the resin substrate side, but a copper foil circuit was formed broader toward the end. Subsequently, the inclination angle of the etched copper foil was measured (it is the minimum value of the inclination angle in the circuit length of 100 µm).
Moreover, the etching factor and the oxidative discoloration (YAKE) of the nickel plated surface were examined. The foregoing results are also shown in Table 1. As shown in Table 1, the average value of the inclination angle of both sides was 52 degrees, and a trapezoidal copper foil circuit with inferior etching properties was formed. The etching factor was 1.3 with the 30 µm pitch, and became inferior. Nevertheless, there was no oxidative discoloration (YAKE) of the copper foil surface.

### (Comparative Example 7)

An electrolytic copper foil of 5 µm was used. The surface roughness Rz of the electrolytic copper foil was 0.5 µm. As shown in Table 1, a nickel-zinc alloy plated layer of 4100 µg/dm² was formed on the electrolytic copper foil. Here, the nickel content was 3500 µg/dm² and the zinc content was 600 µg/dm² in the nickel alloy layer. The nickel ratio was 85 wt%. The copper foil was bonded to a resin substrate with the adhesive surface opposite to the surface provided with the nickel alloy plated layer.

Subsequently, as with Example 1, a circuit with 10 lines was printed with the process steps of resist coating and exposure, and etching treatment was further performed to remove any unwanted part of the copper foil.
The etching conditions, measurement conditions of the etching factor, and YAKE experiment, but excluding the circuit forming conditions, were the same as Example 1. Thus, the description of conditions that overlap with Example 1 is omitted.
(Formation of a circuit with 30 µm pitch)
Resist L/S = 25 µm/5 µm; top (upper part) width of finished circuit: 10 µm; etching time: around 76 seconds

Etching was performed under the foregoing conditions. Consequently, etching proceeded from the resist side of the side surface of the copper circuit toward the resin substrate side, and a copper foil circuit was formed. Subsequently, the inclination angle of the etched copper foil was measured (it is the minimum value of the inclination angle in the circuit length of 100 µm).
Moreover, the etching factor and the oxidative discoloration (YAKE) of the nickel plated surface were examined. The foregoing results are also shown in Table 1. As shown in Table 1, the average value of the inclination angle of both sides was 76 degrees, and the etching properties were favorable. The etching factor was 3.9 with the 30 µm pitch. There was no oxidative discoloration (YAKE) of the copper foil surface, but the soft etching properties were inferior. The reason for this is considered to be the excessive amount of nickel.

### (Comparative Example 8)

A rolled copper foil of 18 µm was used in Comparative Example 8. The surface roughness Rz of the rolled copper foil was 0.5 µm. As shown in Table 1, a nickel-zinc alloy plated layer of 130 µg/dm² was formed on the rolled copper foil. Here, the nickel content was 80 µg/dm² and the zinc content was 50 µg/dm² in the nickel alloy layer. The nickel ratio was 62 wt%. The copper foil was bonded to a resin substrate with the adhesive surface opposite to the surface provided with the nickel alloy plated layer.

Subsequently, as with Example 1, a circuit with 10 lines was printed with the process steps of resist coating and exposure, and etching treatment was further performed to remove any unwanted part of the copper foil.
The etching conditions, measurement conditions of the etching factor, and YAKE experiment, but excluding the circuit forming conditions, were the same as Example 1. Thus, the description of conditions that overlap with Example 1 is omitted.
(Formation of a circuit with 50 µm pitch)
Resist L/S = 25 µm/5 µm; top (upper part) width of finished circuit: 10 µm; etching time: around 76 seconds

Etching was performed under the foregoing conditions. Consequently, etching proceeded from the resist side of the side surface of the copper circuit toward the resin substrate side, and a copper foil circuit was formed. Subsequently, the inclination angle of the etched copper foil was measured (it is the minimum value of the inclination angle in the circuit length of 100 µm).
Moreover, the etching factor and the oxidative discoloration (YAKE) of the nickel plated surface were examined. The foregoing results are also shown in Table 1. As shown in Table 1, the average value of the inclination angle of both sides was 56 degrees, a copper foil was etched broader toward the end, and the etching properties were inferior. The etching factor was 1.6 with the 50 µm pitch. There was no oxidative discoloration (YAKE) of the copper foil surface.

### (Comparative Example 9)

A rolled copper foil of 9 µm was used in Comparative Example 9. The surface roughness Rz of the rolled copper foil was 0.5 µm. As shown in Table 1, a nickel-zinc alloy plated layer of 570 µg/dm² was formed on the rolled copper foil. Here, the nickel content was 550 µg/dm² and the zinc content was 20 µg/dm² in the nickel alloy layer. The nickel ratio was 96 wt%. The copper foil was bonded to a resin substrate with the adhesive surface opposite to the surface provided with the nickel alloy plated layer.

Subsequently, as with Example 1, a circuit with 10 lines was printed with the process steps of resist coating and exposure, and etching treatment was further performed to remove any unwanted part of the copper foil.
The etching conditions, measurement conditions of the etching factor, and YAKE experiment, but excluding the circuit forming conditions, were the same as Example 1. Thus, the description of conditions that overlap with Example 1 is omitted.
(Formation of a circuit with 30 µm pitch)
Resist L/S = 25 µm/5 µm; top (upper part) width of finished circuit: 10 µm; etching time: around 76 seconds

Etching was performed under the foregoing conditions. Consequently, etching proceeded from the resist side of the side surface of the copper circuit toward the resin substrate side, and a copper foil circuit was formed. Subsequently, the inclination angle of the etched copper foil was measured (it is the minimum value of the inclination angle in the circuit length of 100 µm).
Moreover, the etching factor and the oxidative discoloration (YAKE) of the nickel plated surface were examined. The foregoing results are also shown in Table 1. As shown in Table 1, the average value of the inclination angle of both sides was 68 degrees, and the etching properties were favorable. The etching factor was 2.5 with the 30 µm pitch. Nevertheless, oxidative discoloration (YAKE) was occurred on the copper foil surface. The reason for this is considered to be the less amount of zinc.

### (Comparative Example 10)

An electrolytic copper foil of 5 µm was used in Comparative Example 10. The surface roughness Rz of the electrolytic copper foil was 0.5 µm. As shown in Table 1, a nickel-zinc alloy plated layer of 730 µg/dm² was formed on the electrolytic copper foil. Here, the nickel content was 330 µg/dm² and the zinc content was 400 µg/dm² in the nickel alloy layer. The nickel ratio was 45 wt%. The copper foil was bonded to a resin substrate with the adhesive surface opposite to the surface provided with the nickel alloy plated layer.

Subsequently, as with Example 1, a circuit with 10 lines was printed with the process steps of resist coating and exposure, and etching treatment was further performed to remove any unwanted part of the copper foil.
The etching conditions, measurement conditions of the etching factor, and YAKE experiment, but excluding the circuit forming conditions, were the same as Example 1. Thus, the description of conditions that overlap with Example 1 is omitted.
(Formation of a circuit with 30 µm pitch)
Resist L/S = 25 µm/5 µm; top (upper part) width of finished circuit: 10 µm; etching time: around 76 seconds

Etching was performed under the foregoing conditions. Consequently, etching proceeded from the resist side of the side surface of the copper circuit toward the resin substrate side, and a copper foil circuit was formed. Subsequently, the inclination angle of the etched copper foil was measured (it is the minimum value of the inclination angle in the circuit length of 100 µm).
Moreover, the etching factor and the oxidative discoloration (YAKE) of the nickel plated surface were examined. The foregoing results are also shown in Table 1. As shown in Table 1, the average value of the inclination angle of both sides was 56 degrees, a copper foil was etched broader toward the end, and the etching properties were inferior. The etching factor was 1.5 with the 30 µm pitch. There was no oxidative discoloration (YAKE) of the copper foil surface, but the etching properties were inferior. The reason for this is considered to be that the nickel ratio was low.

**[Table 1]**

| | Base foil | Foil Thickness (µm) | Type of Metal Layer | Ni Content (µg/dm²) | Zn (µg/dm²) | Ni Ratio wt% | EF 30µm pitch | EF 50µm pitch | Inclination Angle (degrees) | Occurrence of YAKE | Soft Etching Properties |
|---|---|---|---|---|---|---|---|---|---|---|---|
| Example 1 | Electrolytic copper foil | 5 | A1 | 350 | 40 | 90 | 3 | | 72 | None | ○ |
| Example 2 | Rolled copper foil | 18 | A2 | 1500 | 650 | 70 | | 3.4 | 74 | None | ○ |
| Example 3 | Rolled copper foil | 18 | A3 | 2500 | 300 | 66 | | 3.5 | 74 | None | ○ |
| Example 4 | Electrolytic copper foil | 5 | A4 | 110 | 40 | 71 | 2.8 | | 70 | None | ○ |
| Example 5 | Rolled copper foil | 9 | A5 | 250 | 50 | 71 | 2 | | 63 | None | ○ |
| Example 6 | Rolled copper foil | 9 | A6 | 920 | 550 | 59 | 3 | | 72 | None | ○ |
| Example 7 | Rolled copper foil | 18 | A7 | 800 | 200 | 79 | | 3.1 | 72 | None | ○ |
| | | | | | | | | | | | |
| Comparative Example 1 | Rolled copper foil | 9 | A0 | 550 | | 100 | 2.5 | | 68 | Occurred | ○ |
| Comparative Example 2 | Rolled copper foil | 18 | A8 | | 270 | 0 | | 1.1 | 48 | None | ○ |
| Comparative Example 3 | Electrolytic copper foil | 5 | A8 | | 240 | 0 | 1.4 | | 54 | None | ○ |
| Comparative Example 4 | Rolled copper foil | 9 | A8 | | 270 | 0 | 1.2 | | 52 | None | ○ |
| Comparative Example 5 | Rolled copper foil | 18 | A1 | 1000 | 1750 | 36 | | 1.9 | 52 | None | ○ |
| Comparative Example 6 | Rolled copper foil | 9 | A1 | 650 | 1600 | 29 | 1.3 | | 52 | None | ○ |
| Comparative Example 7 | Electrolytic copper foil | 5 | A1 | 3500 | 600 | 85 | 3.9 | | 76 | None | × |
| Comparative Example 8 | Rolled copper foil | 18 | A1 | 80 | 50 | 62 | | 1.6 | 56 | None | ○ |
| Comparative Example 9 | Rolled copper foil | 9 | A1 | 550 | 20 | 96 | 2.5 | | 68 | Occurred | ○ |
| Comparative Example 10 | Electrolytic copper foil | 5 | A1 | 330 | 400 | 45 | 1.5 | | 56 | None | ○ |

| | | | | | | | | | | | |
|---|---|---|---|---|---|---|---|---|---|---|---|
| EF: Etching factor *Type of metal layer A0 Nickel plating A1 Nickel-zinc alloy plating, part 1 A2 Nickel-zinc alloy plating, part 2 A3 Nickel-cobalt-zinc alloy plating A4 Nickel-phosphorus-zinc alloy plating A5 Nickel-molybdenum-zinc alloy plating A6 Nickel-tungsten-zinc alloy plating A7 Nickel-boron-zinc alloy plating A8 Zinc plating | | | | | | | | | | | |

### INDUSTRIAL APPLICABILITY

The present invention yields the effect of being able to form a uniform circuit having the intended circuit width when forming a circuit by etching a copper foil, and yields the additional effects of being able to prevent sagging caused by the etching, shorten the time of forming a circuit by etching, make the thickness of the nickel alloy layer as thin as possible, inhibit oxidation when exposed to heat, and prevent tarnish (discoloration) known as "YAKE". Since it is thereby possible to improve the etching properties in pattern etching and to prevent the occurrence of short circuits and defects in the circuit width, the present invention can be used as a copper-clad laminate (rigid or flexible), and also used for forming an electronic circuit of a printed substrate.

## Claims

1. A rolled copper foil or electrolytic copper foil for an electronic circuit, wherein the rolled copper foil or electrolytic copper foil to be used for forming an electronic circuit by etching comprises a nickel alloy layer with a lower etching rate than copper formed on an etching side of the copper foil, and the nickel alloy layer contains zinc or zinc oxide.

2. The rolled copper foil or electrolytic copper foil for an electronic circuit according to claim 1, wherein the nickel ratio in the nickel alloy layer with a lower etching rate than copper exceeds 50 wt%.

3. The rolled copper foil or electrolytic copper foil for an electronic circuit according to any one of claims 1 and 2, wherein the amount of zinc contained as zinc or zinc oxide in the nickel alloy layer is 30 µg/dm² to 1000 µg/dm² based on metal zinc conversion and does not exceed the amount of nickel.

4. The rolled copper foil or electrolytic copper foil for an electronic circuit according to any one of claims 1 to 3, wherein the amount of nickel contained in the nickel alloy layer is 100 µg/dm² to 3000 pg/dm².

5. The rolled copper foil or electrolytic copper foil for an electronic circuit according to any one of claims 1 to 4, wherein the nickel alloy layer contains one or more elements selected from phosphorus, boron, molybdenum, tungsten, and cobalt.

6. The rolled copper foil or electrolytic copper foil for an electronic circuit according to any one of claims 1 to 5, wherein the copper foil further comprises a chromium layer or a chromate layer and/or a silane-treated layer on the nickel alloy layer.

7. The rolled copper foil or electrolytic copper foil for an electronic circuit according to claim 6, wherein the amount of chromium in the case of comprising the chromium layer or chromate layer is 100 µg/dm² or less based on metal chromium conversion.

8. The rolled copper foil or electrolytic copper foil for an electronic circuit according to claims 6 and 7, wherein the amount of silane in the case of comprising the silane-treated layer is 20 µg/dm² or less based on silicon elemental conversion.

9. A method of forming an electronic circuit, the method of forming an electronic circuit by etching a copper foil of a copper-clad laminate comprising a rolled copper foil or electrolytic copper foil, wherein a nickel alloy layer containing zinc or zinc oxide is formed on the etching side of the copper foil, and thereafter the copper foil is subject to etching with an aqueous ferric chloride or an aqueous copper chloride to remove any unwanted portion of the copper foil and thereby form a copper circuit.

10. A method of forming an electronic circuit, the method of forming an electronic circuit by etching a copper foil of a copper-clad laminate comprising a rolled copper foil or electrolytic copper foil, wherein the rolled copper foil or electrolytic copper foil for an electronic circuit according to any one of claims 1 to 8 is subject to etching with an aqueous ferric chloride or an aqueous copper chloride to remove any unwanted portion of the copper foil and thereby form a copper circuit.
